# EUROPEAN PATENT APPLICATION

(11) **EP 2 060 985 A1**
(43) Date of publication of application: **20.05.2009**
(21) Application number: 07425712.2
(22) Date of filing: 12.11.2007
(51) Int. Cl.: G06F 17/50

(54) **Functional testing method and device for an electronic product**

(71) Applicant: 2M Soft. di Marco Marcinno', 10070 Grosvallo (IT)
(72) Inventor: Marcinno Marco, 10070 Groscavallo (IT)
(74) Representative: Cinquantini, Bruno

(57) **Abstract**

There is described a functional testing method of an electronic product which contemplates the writing of a document defining a functional specifications of a product by means of a formalism and a functional specification model adapted to define the functional specification, so that this is comprehensible by human and non-human interpreters, thus automating the setting up of a functional testing apparatus of electronic products. Said functional testing apparatus, being adapted to interpret said document, is general-purpose and comprises interface means with corresponding drivers, replaceable in relation to the type of product subject to functional test.

## Description

### Field of the invention

The present invention relates to the field of electronic board or apparatus testing, and more specifically to a functional testing method and device for an electronic product.

### State of the art

There is a remarkable gap in the known art concerning the transfer of information from the design to the automatic functional testing systems.

Currently, the transfer takes place by means of a written documentation in human language, the so-called functional specification. It is also widespread opinion that the design responsibility regarding the arrangement of such information is not clearly assigned.

Specifically, in order to verify the performances of a product, a functional specification specifies what needs to be done, with what means and in which sequence.

This gap, i.e. the use of a human language for treating fundamental information for the industrialization of a product, is translated into a considerable cost in terms of human resources and time.

As a consequence, the document expressed in human language must be interpreted to make a functional testing apparatus. Furthermore, each apparatus is dedicated to that specific product. In other words, it is impossible to make general purpose functional testing systems.

The functional test of electronic boards is a known and needed requirement to verify that an electronic product works according to specifications, however this is a need which appears in three different moments of an electronic product life, i.e. during prototyping, production and reconditioning. Normally, the functional test is recognized as a production need, i.e. that test which must be performed at the end of production before delivering the product.

The industrialization process of electronic boards and systems has also set up other types of tests which focus on other aspects but which may be grouped into a category named category of components or circuit category: in-circuit test, boundary scan, optical inspection, X-ray inspection.

All these procedures essentially differ from the functional test because they do not consider how the components interact, how they "work" exactly, but only whether the single parts are present and in tolerance with respect to the design information and the industrial process quality, in terms of welding and assembly.

Therefore, the analysis results to be related to the functionality of the single components loosing sight of the reason why they have been combined together to form the product.

In medium - small sized companies, the designer him or herself may provide support for the design of the functional testing system and a system is able to cover the test of the entire whole of that company's products with some difficulties and, anyway, each product needs an adaptation for the interconnection to the testing system.

The typical layout of an automatic or semiautomatic functional tester contemplates a PC connected to a testing system which by means of an adapting interface allows to test a product.

The company's own boards or boards supplied by third parties may be used for making testing systems. The same applies to the software for controlling the system.

No one provides a development environment of the functional specification, with a separation between the informative part and the executive part, regardless of the hardware used.

In other words, a software environment is used for the electronic designing, while the so-called documentation is written before, during and after the step of designing, in correlated manner to the step of designing itself, to the extent that only during the step of testing it is possible to highlight any discrepancies between what is shown in the documentation and what has been really designed.

The products provided by the known art intend to make tools for developing a software for testing systems available to users without programming notions, in a simple manner e.g. graphically, but do not offer any support in writing the functional specification which must be a document which develops hand-in-hand with the project.

The industrialization processes of electronic products may be summarized in:
- defining a functional specification;
- writing a text;
- interpreting said text by one or more people;
- setting up a dedicated system, also beginning from the use of general-purpose commercial products, which must be adapted to the various needs.

The foregoing schematization shows two considerable gaps: the first one is the lack of a standardized functional specification model with the consequent need for one or two people who must design and make a testing system. This determines costs in terms of:
- human resources
- time needed to implement the testing systems
- errors generated by the interpretation of the human language text: during testing system verification it is often necessary to go from production back to design: this means that something written in the functional specification is not coherent with the product.

The second one is the lack of definition of the architectural requirements of a general-purpose functional testing system, which produces a proliferation of reciprocally similar yet different hardware systems dedicated to single products, which are not only expensive to replicate but also expensive to maintain.

### Summary of the invention

It is the object of the present invention to provide a functional testing method for an electronic product.

Therefore, the present invention aims at reaching the objects discussed above by means of a functional testing method for an electronic product according to claim 1.

A further object of the present invention is to provide a device of the general purpose type, working according to said method.

Therefore the present invention aims at reaching the objects discussed above by means of a functional testing device for an electronic product according to claim 11.

According to another aspect of the invention, said method finds the best application when integrated in a software environment which assists the electronic design, so that the documentation defining a functional specification is automatically written by said environment according to a predetermined formalism directly interpretable by said functional testing device, so as to avoid the effort of writing said documentation in human language, of later interpreting it and of setting up a specific testing system.

The dependent claims describe preferred embodiments of the invention.

### Brief description of the Figures

Further features and advantages of the invention will be more apparent in the light of the detailed description of a preferred, but not exclusive, embodiment of a functional testing method and device for an electronic product illustrated by way of non-limitative example, with the aid of the accompanying drawings, in which:
Fig. 1 diagrammatically shows an electronic document writing defining a functional specification parallelly to the setting up of an electronic circuit or product, which is adapted to be automatically interpreted by a testing device;
Fig. 2 shows a static model, according to the UML notation, of functional specification in which the blocks are labeled with the names of the corresponding classes;
Fig. 3 shows the usual logical-functional connections of the UML notation;
Fig. 4 shows an object-oriented logical-functional model of a general-purpose functional testing system according to the UML notation;
Fig. 5 shows definition examples of the FunctionalSpecDoc, Step and Module classes.

### Detailed description of a preferred embodiment of the invention

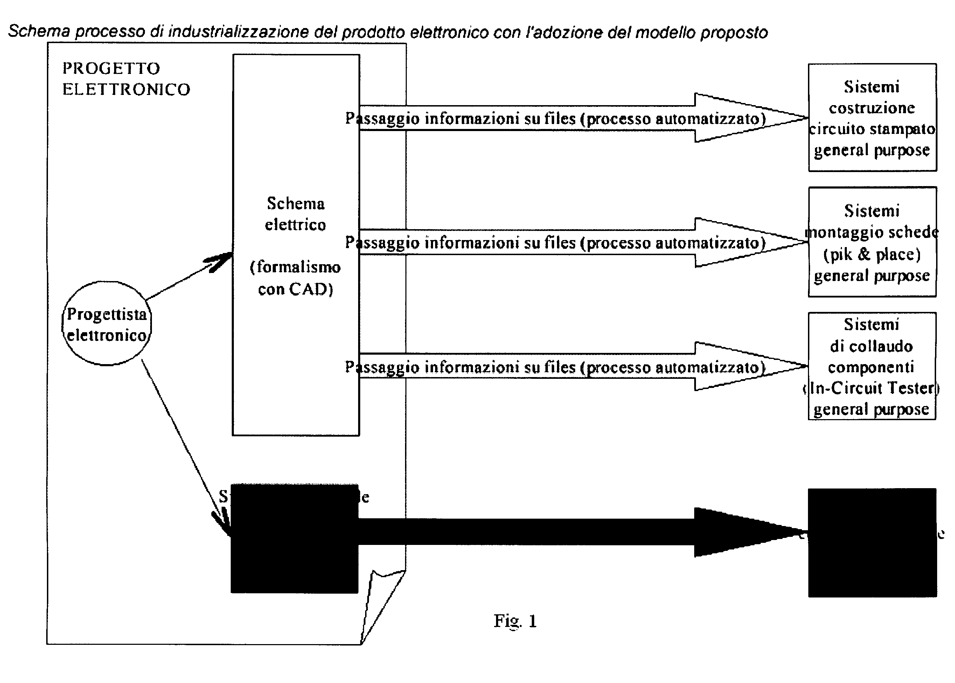

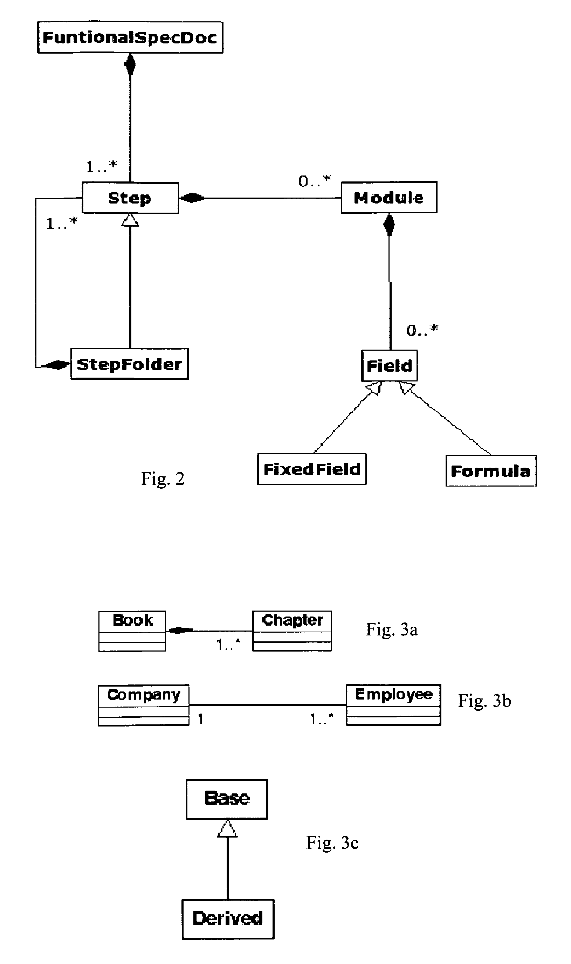

With reference to Figures 1 and 2, it is proposed a functional testing method of an electronic product comprising the following steps of:
- preparing a document defining a functional specification related to a product according to a predetermined formalism and model;
- interpreting said document;
- verifying to ascertain the compliance of said product on the basis of the contents of the corresponding functional specification.

In the case in point, said verification actions are implemented by means of a functional testing device comprising:
- processing means adapted to interpret a document written according to a predetermined formalism and model, defining a functional specification of a product;
- hardware interfacing means with said product adapted to perform a functional testing trial;
- interface means (drivers) between said processing means and said hardware interfacing means.

A preferred embodiment of said device comprises a further integrated software working environment, which assists the electronic designing and is adapted to simultaneously and automatically write said document defining said functional specification. Therefore, said document may be written by means of an appropriate distinct tool (i) separate from the electronic designing environment.

In another preferred embodiment, said tool is integrated (ii) in said electronic designing environment, so that said document is automatically written during the electronic design by the designing environment itself.

In a further preferred embodiment, said electronic designing environment integrating said functional specification writing tool is integrated (iii) in the functional testing device.

In another preferred embodiment, said functional testing device simultaneously integrating said electronic designing environment adapted to automatically write said document defining a functional specification, further comprises (iv) means for the automatic production of an electronic board or product designed by means of said electronic designing environment.

In the latter embodiment, it is apparent that a single apparatus may be used to design an electronic board, to write a functional specification thereof, to manufacture the designed board and to test it.

Specifically, with reference to figure 1, an electronic designer is, by virtue of the present invention, conditioned to simultaneously define both the circuit and the function and performance features of the product.

A preferred functional specification model is shown with reference to figure 2. To better understand said figure, reference is made to figures 3a and 3b.

Specifically, figure 3a shows an aggregation, i.e. the fact that a chapter entity is part of a book, in its individuality. Therefore, the line in proximity of the chapter block is thicker indicating the predominance of this entity, without which the other entity has no reason to exist. On the contrary, figure 3b shows a company/employee association in which one has reason to exist independently from the other. Finally, figure 3c shows the concept of inheritance derived from object-oriented programming.

Given this introduction, the model in figure 2 comprises:
- at least one step, defined by a class called Step, in which the symbol "1..*" represents the algebraic multiplicity thereof and is read as from one to infinity.

Each step comprises from 0 to infinite modules, defined by the Module class, and each module comprises from 0 to infinite programming fields, defined by the Field class.

The steps are hierarchically grouped so that the Step Folder class is derived from the Step class, according to the object-oriented programming inheritance, which contains from 1 to infinite steps.

This model has a recursive structure easily implementable in any object-orientated programming language and ascribable to simple recursive algorithms. Specifically, reference is made to a formalism known with the acronym UML.

The cycling of the Step Folder class on the Step class indicates a recursion which would identify an infinite tree, if explicated, in which the dependence between the nodes has a functional and temporal feature. For example, in the tree, the passage through a node which contemplates the starting of a component is a mandatory step along the path leading to a further node in which the supply voltage of that component is taken to a certain value.

Due to the inheritance linking the Step Folder and Step classes, a functional testing condition may be introduced only once in the parent step, thus being valid and known for the deriving classes, or may be altered in the classes which derive therefrom.

Advantageously, variations to the values of the attributes only need to be carried out when these vary with respect to the previous step.

Furthermore, the values set in the fields may be passed by value or by reference, as occurs for example in electronic spreadsheets.

It is apparent that this modeling does not refer to the executive part of the testing specification and thus to the functionality of the testing device.

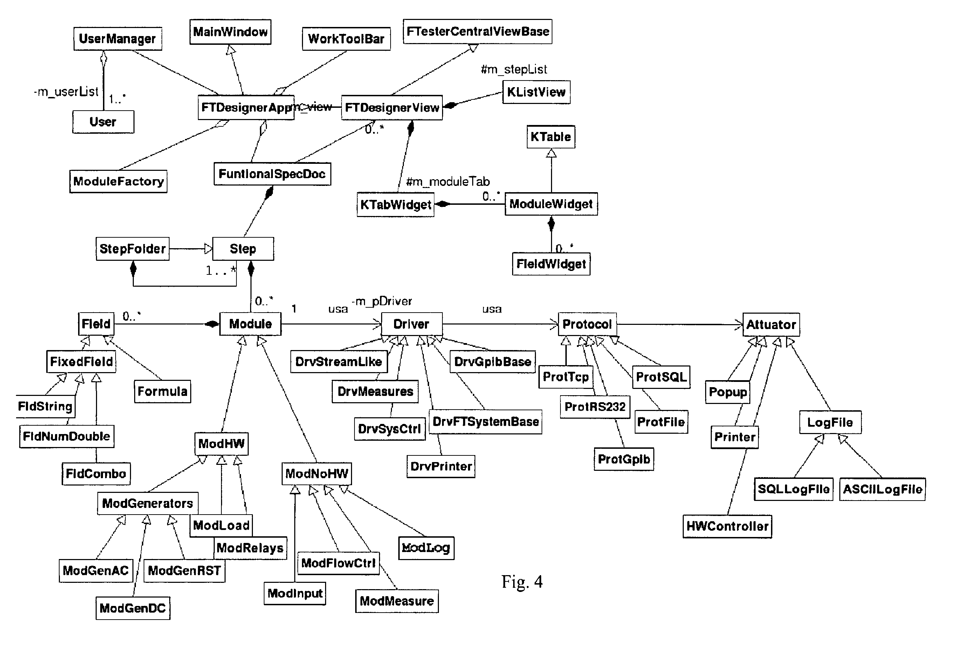

Said testing device interprets said document which defines the functional specification according to a method, also schematizable by means of the notation derived from UML, as shown in figure 4.

The above-described model defining the functional specification is integrated in the central part of the diagram by the classes: FunctionalSpecDoc, Step, StepFolder, Module, Field, FixedField and Formula.

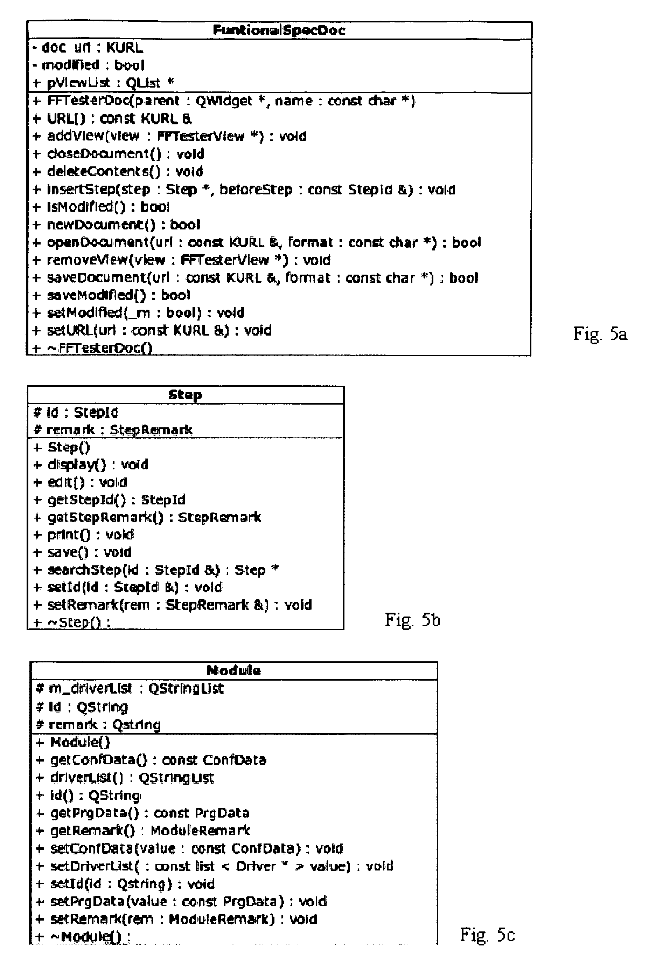

Examples of defining some of the aforesaid classes are shown in figure 5.

The Module and Field classes are to be seen as interfaces in the UML notation, i.e. they describe the methods with which they connect to other classes, and are implemented by derived objects.

Thus, the Field interface is implemented by the FixedField classes of FldString type for strings, FldNumDouble for floating point numerical fields, FldCombo for predetermined value selection fields, while the Formula class implements formulae which may contain Field object values. Specifically, a Formula class may involve the value of a field either of the same module or of another module in the calculation. This function is very useful, for example, when aiming at seting the supply voltage of a given component to a value 10% higher than the nominal value. Therefore, with a formula one takes the current value and divides it by 0.9 obtaining the correct value independently from the nominal value, which has been set in StepFolder.

Thus the Module interface, which may be for example a template of modules, may be specialised either in hardware controlling modules, e.g. the ModHW class, or in modules which do not control hardware, such as the ModNoHW class, which are implemented respectively by the ModGenerators classes and their derivates ModGenAC, ModGenDC and ModGenRST for generators, ModLoad for loads and ModRelays for relays, ModInput for the operator interface hardware, ModFlowCtrl for the execution flow control, such as cycles, breaks, parallelism/sequencing; ModMeasure for the step validation, ModLog for the measured data collection.

The separation between the informative part, i.e. the functional specification, and the executive part, which refers to electronic components such as actuators, is apparent. Thus, the modules become executive by means of the Attuator class by driving the actuators by virtue to a driver defined by the Driver class which transfers the information contained in Module to Attuator by means of a protocol defined by the Protocol class.

The Driver, Protocol and Attuator objects are considered interfaces in the UML notation, i.e. they describe the methods by means of which the objects are connected, but are implemented by derived objects.

Likewise, the Driver interface is implemented by the DrvStreamLike classes for all the modules which have actuators which are managed by means of a data stream, DrvMeasures for the step validating module, DrvSysCtrl allowing to modify the step execution stream, which may be either a cycle, or a stop, or a break, or a parallelism/sequencing; DrvGpibBase for the basic management module of the instruments connected to the standardized GPIB interface according to the IEEE488 standard; DrvPrinter for managing the output towards printers; DrvFTSystemBase for managing all the modules implemented for the general-purpose functional testing system.

Likewise, the Protocol interface is implemented by the ProtTCP classes for the TCP/IP protocol; ProtRS232 for the RS232 protocol; ProtGpib for the GPIB protocol; ProtFile for referring to local or remote file systems; ProtSQL for accessing a SQL database.

Likewise, the Attuator interface is implemented by the Popup classes for managing the screen displays to interact with an operator; Printer defines a local or remote printer; LogFile is a collection of test data which may be defined by SQLLogFile, thus in a SQL database or ASCIILogFile in a ASCII file; HWController defines a smart manager of the hardware modules implemented for the general-purpose functional testing system which may be a common CPU board, a relay board, a generator, a load or any combination of foregoing hardware modules. A further common board may be a digital I/O with 2 digital/analogue DAC channels and 2 analogue/digital ADC channels with floating scale management.

This board, which may be implemented for the functional test, is the base to control any generator/load hardware module, to analize the digital and analogue signals and to measure them.

All these objects are contained in a FTDesignerApp class which manages the users by means of the UserManager and User classes, and which contains a collection of modules such as the ModuleFactory class, a main window defined by the MainWindow class, a working tool bar defined by the WorkToolBar class and one or more functional testing specification views defined by the FTDesignerView class.

Except for the latter class, the other objects are typical of any framework library for window applications (Windows, KDE/Linux). Reference shall be made to the development of applications with event-driven graphic interfaces for implementing details.

On the other hand, the FTDesignerView class defines the functional specification display.

There may be various views, by modules, by steps, etc.

A KlistView class defines a hierarchic list for containing the list of steps and the view of the module defined by the ModuleWidget class, which may be contained in a folder defined by the KtabWidget class as in electronic spreadsheets. The ModuleWidget may be derived from a class which implements a table defined by the Ktable class, again similar to the electronic spreadsheet. Moreover, the ModuleWidget consists of views of various field defined by the FieldWidget class.

The view intended to be used by an operator-repairer is instead organized in a container in which there are all the hardware driving modules a, e.g. ModHW, and with only the main fields, so as to be able to stop the test at the first step in which a fault appears, allowing a more convenient repair because it is possible to vary the module parameters, i.e. the Module objects, so that the inputs of a certain component defining the board under testing are varied.

With regards to the views, it is preferable to implement the so-called concept of document-view which can be implemented using any framework library with event-driven graphic interface and it is thus possible to organize more suitable views of the functional specification document for the end user and also as higher level of data abstraction (predetermined steps as specific test library for the application). This is a further development of the application which does not modify the basic layout.

A person skilled in the art, specifically a person skilled in object-oriented programming and formalisms such as UML, will find no difficulty in understanding the modeling technique employed in the present invention, and thus the construction of a device for implementing the above-described method is within the skilled person's reach.

In virtue of the present invention, there is illustrated a method for solving the problem of electronic board functional test allowing unquestionable advantages for electronic companies in:
- defining a functional specification by means of a formalism;
- modeling a general-purpose functional testing system.

The first aspect determines the following advantages:
- the separation between the information related to the functional specification and the implementing information, so as to make it possible to make general-purpose functional testing systems;
- the setting up of a CAD tool used by the electronic designer him or herself for writing the functional specification, by means of which it is possible to transfer his or her competence information directly to the functional testing system, without needing encoding and interpretation, thus automating the product industrialization process also under the functional aspect, with consequent cost reduction due to the number and qualification of the people who are involved in functional test during the production;
- the automatic parallel testing of several equivalent devices by using hardware resources, also heterogeneous, present in the testing system and otherwise not used in a single test and the consequent reduction of the test time which is translated into a reduction of testing costs with respect to the single test without an increase of the cost of the testing system. It is worth noting that this aspect is very important in the functional test because the test time greatly depends on the device itself and is statistically high compared with the handling time of the piece. Therefore, the testing time is not compressible for a testing system of equal efficiency in which automatic parallel testing is not performed;
- the single management of the functional specifications of the company's own products, so that they are comprehensible by people and machines, inside and outside the same company;
- the management of documentation in human language, which may be thus generated automatically from a modeled functional specification;
- the possibility of outsourcing the functional test providing only one file containing the functional specification;
- the possibility for outsourcers to provide a functional testing service without knowing the implementing features of the product, but being only able to interpret the specification in the light of the formalism with which it is written.

The second aspect determines the following advantages:
- the creation of testing systems formed by a low number of components yet adapted to test all types of products of a company;
- the cost reduction of the functional testing systems and their maintenance.
   Specifically, with a minimum number of boards it is possible to form testing apparatuses adapted to meet nearly all of the company's needs. For the small remaining number of companies requiring specific functions, said minimum number of common boards are used as components for integrating actuator systems which perform these specific functions.

The specific embodiments herein described do not limit the content of this application which covers all the variants of the invention defined in the claims.

## Claims

1. A functional testing method for an electronic product comprising the steps of:
- preparing a document defining a functional specification related to a product according to a predetermined formalism and model;
- interpreting said document;
- verifying the compliance of said product on the basis of the contents of the corresponding functional specification.

2. A method according to claim 1, wherein said formalism is of the object-oriented type.

3. A method according to claim 2, wherein said formalism is UML.

4. A method according to claim 1, wherein said model comprises a first class (FunctionSpecDoc) aggregated to a second class (Step) aggregated to a third class (Module), said second class being parent of a fourth class (StepFolder), to which it is aggregated and any of said classes being adapted to be specialised so as to drive interface means (drivers) by means of which it is possible to control the hardware interfacing means and the user interface means.

5. A method according to claim 4, wherein the multiplicity of said second class (Step) is from 1 to infinity.

6. A method according to claim 4, wherein the multiplicity of said third class (Module) is from 0 to infinity.

7. A method according to claim 4, wherein the multiplicity of said fourth class (StepFolder) is from 1 to infinity.

8. A method according to claim 4, wherein said third class (Module) aggregates a fifth class (Field).

9. A method according to claim 8, wherein said fifth class (Field) has a multiplicity from 0 to infinity.

10. A method according to claim 8, wherein said fifth class (Field) is the parent of two further classes (FixedField, Formula) adapted to specialise said fifth class by inheritance.

11. A functional testing device for an electronic product comprising:
- processing means adapted to interpret a document written according to a predetermined formalism and model, defining a functional specification of a product;
- hardware interfacing means with said product adapted to perform a functional testing trial;
- interface means (drivers) between said processing means and said hardware interfacing means.

12. A device according to claim 11, wherein said processing means operate according to a model respecting UML formalism comprising a first class (FunctionSpecDoc) aggregated to a second class (Step) aggregated to a third class (Module), said second class being parent of a fourth class (StepFolder), to which is aggregated and any of said classes being adapted to be specialised so as to drive said interface means (drivers) by means of which it is possible to control said hardware interfacing means and further user interface means.

13. A device according to claim 12, wherein the multiplicity of said second class (Step) is from 1 to infinity.

14. A device according to claim 12, wherein the multiplicity of said third class (Module) is from 0 to infinity.

15. A device according to claim 12, wherein the multiplicity of said fourth class (StepFolder) is from 1 to infinity.

16. A device according to claim 12, wherein said third class (Module) aggregates a fifth class (Field).

17. A device according to claim 11, further comprising (iii) means to assist the elctronic designing, adapted to automatically write said document written according to said formalism and said predetermined model, defining a functional specification of a product.

18. A device according to claim 17, (iv) further provided with means for automatically producing an electronic board or product designed by means of said electronic designing environment.

19. A device to assist the electronic designing (ii) comprising means adapted to automatically write a document written according to a predetermined formalism and model, defining a functional specification of a product.

20. A device to assist the writing of a document (i) written according to a predetermined formalism and model, defining a functional specification of a product.

21. A computer program comprising code means adapted to implement the steps of the claims from 1 to 10, when said program is run on a computer.

22. Computer-readable means comprising a program recorded on them, said means comprising a program code adapted to implement the steps of the claims from 1 to 10, when said program is run on a computer.
